# EUROPÄISCHE PATENTSCHRIFT

(11) **EP 3 111 474 B1**
(45) Veröffentlichungstag und Bekanntmachung des Hinweises auf die Patenterteilung: **23.06.2021**
(21) Anmeldenummer: 15711033.9
(22) Anmeldetag: 20.02.2015
(51) Int. Cl.: H01L 23/538, H05K 3/00, H05K 3/20, H01L 21/683, H05K 1/18, H01L 23/31

(54) **VERFAHREN ZUM HERSTELLEN EINER LEITERPLATTE MIT EINGEBETTETEM SENSORCHIP SOWIE LEITERPLATTE**
METHOD FOR PRODUCING A PRINTED CIRCUIT BOARD WITH AN EMBEDDED SENSOR CHIP, AND PRINTED CIRCUIT BOARD
PROCÉDÉ DE FABRICATION D'UN CIRCUIT IMPRIMÉ À PUCE DE CAPTEUR INCORPORÉE AINSI QUE CIRCUIT IMPRIMÉ

(30) Priorität: 28.02.2014 AT 501542014
(43) Veröffentlichungstag der Anmeldung: 04.01.2017
(73) Patentinhaber: AT&S Austria Technologie & Systemtechnik Aktiengesellschaft, 8700 Leoben (AT)
(72) Erfinder: WEIDINGER, Gerald, A-8700 Leoben (AT)
(74) Vertreter: Patentanwaltskanzlei Matschnig & Forsthuber OG
(86) Internationale Anmeldenummer: PCT/AT2015/050046
(87) Internationale Veröffentlichungsnummer: WO 2015/127486

(56) Entgegenhaltungen:
- WO-A1-2013/029073
- WO-A1-2013/029074
- WO-A2-2009/006284
- JP-A- 2002 231 762
- JP-A- 2007 158 293
- JP-A- 2011 082 583
- JP-A- 2012 112 728
- US-A1- 2008 057 233
- US-A1- 2010 142 170
- US-A1- 2011 180 891

## Beschreibung

Die Erfindung bezieht sich auf ein Verfahren zum Herstellen einer Leiterplatte mit zumindest einem eingebetteten Sensorchip, bei welchem Sensorfläche und Anschlüsse auf einer Fläche des Chips angeordnet sind.

Die Erfindung bezieht sich auch auf eine Leiterplatte, bestehend aus zumindest einer Isolierschicht und zumindest einer strukturierten Leiterschicht mit zumindest einem eingebetteten Sensorchip, bei welchem zumindest eine Sensorfläche und Anschlüsse auf einer Fläche des Chips angeordnet sind, die abgewandt von der strukturierten Leiterschicht im Wesentlichen koplanar an einer Fläche der Leiterplatte liegen.

Unter Sensorchips werden im Rahmen der Erfindung Halbleiterbauelemente verstanden, die einen Sensor besitzen, der beispielsweise auf elektromagnetische Strahlung, auf chemische Einflüsse, auf Druck, Kraft, Temperatur etc. reagieren kann, wobei der Chip außer dem eigentlichen Sensor oft Halbleiterbauelemente, ICs und passive elektrische Komponenten enthält. Ein Sensor weist dabei ein Gebiet auf, welches für die zu detektierende Größe empfindlich ist, z.B. für einfallende Lichtstrahlung, oder eine Kraft aufnimmt, eine Membran aufweist etc. und das hier der Einfachheit halber als Sensorfläche bezeichnet wird.

Aus dem Dokument JP 2011082583 ist ein Halbleiterbauteil sowie ein Verfahren zur Herstellung eines solchen Halbleiterbauteils bekannt, wobei ein Sensorchip mit seiner Sensorfläche von außen durch ein von der Sensorfläche beabstandetes Glassubstrat geschützt in einer Kavität des Halbleiterbauteils angeordnet ist. Die Sensorfläche des Sensorchips ist dabei um diese Kavität vom Glassubstrat beabstandet. Beim Herstellungsverfahren ist beim Vergießen von Versiegelungsharz zu beachten, dass durch geeignete Anordnung von Elektrodenkontakten rund um die Sensorfläche des Sensorchips die Kavität des Halbleiterbauteils harzfrei bleibt.

Weiters ist aus dem Dokument US 2011/0180891 A1 ein Halbleiterbauteil sowie ein dazugehöriges Herstellungsverfahren bekannt geworden. Beim dort gezeigten Halbleiterbauteil sind transparente Abdeckungen zum Schutz von innerhalb der Halbleiterstruktur integrierten optischen Sensoren vorgesehen. Die optischen Sensoren sind von den außenliegenden Abdeckungen im Inneren der Halbleiterstruktur beabstandet angeordnet.

Aus der DE 10 2006 045 900 A1 ist ein Verfahren zur Herstellung eines Sensormoduls bekannt geworden, bei welchem mehrere Sensoren mit ihrem Fühlbereich (Sensorfläche) sowie mit ihren Kontaktpunkten (Anschlüssen) auf einem Träger, der beispielsweise aus poliertem Kupfer besteht, angeordnet und dann mit einem Formmaterial, wie ein mit einem Füllmaterial aufgefüllten Epoxidharz umgossen werden. Nach Abkühlen des heißen Formmaterials wird der Träger entfernt, was beispielsweise chemisch mittels Salpetersäure oder mechanisch erfolgen kann und nach einem Zerschneiden liegen einzelne Module vor. Zur Verbindung der Kontaktpunkte mit von dem Träger vorstehenden Kontaktstrukturen, bestehend aus mit Gold beschichtetem Nickel, kann auch ein leitendes und klebendes Dichtungsmaterial eingesetzt werden. Die Problematik des Schutzes der Sensorflächen eines Chips vor chemischen oder mechanischen Einwirkungen während der Herstellung der Module wird in diesem Dokument beschrieben, nicht jedoch jene der Einbettung eines Sensorelementes in eine Leiterplatte und die dabei erforderliche Kontaktierung an eine Leiterstruktur.

US-A-2010142170 offenbart eine Leiterplatte mit Durchkontaktierungen, die in einer Isolierschicht ausgebildet sind. Mindestens zwei Chips sind in der Isolierschicht eingebettet. Die Chips enthalten Kontaktpads, die jeweils an der oberen und unteren Oberfläche der Isolierschicht angeordnet sind. Auf der Isolierschicht sind obere und untere Leiterbahnen angebracht, die mit den Pads der jeweiligen Chips und den Durchkontaktierungen verbunden sind. Lötstoppschichten werden auf der oberen und unteren Oberfläche der Isolierschicht ausgebildet.

Eine Aufgabe der Erfindung liegt darin, einen Sensorchip, bei welchem Sensorfläche und Anschlüsse auf einer Fläche des Chips angeordnet sind, in eine Leiterplatte einzubetten und mit einer Leiterstruktur der Leiterplatte zu kontaktieren, wobei dies sicher und unter besonderer Schonung der Sensorfläche auf möglichst einfache Weise erfolgen soll. Eine weitere Aufgabe liegt in der Schaffung einer einfach herstellbaren und sehr dünn ausführbaren Leiterplatte mit einem eingebetteten Sensorchip.

Diese Aufgaben werden mit einem Verfahren gemäß Anspruch 1 und einer Leiterplatte gemäß Anspruch 8 gelöst.

Bei einer vorteilhaften Variante ist die leitfähige Paste ein Epoxidharzkleber.
Weiters ist es zweckmäßig, wenn in Schritt e) das Aushärten durch Anwendung von UV-Licht und/oder Wärme erfolgt.

Bei einer praxisbewährten Ausführung ist die Leiterschicht eine Kupferschicht.

Besonders im Fall der Verwendung eines Epoxidharzklebers als leitfähige Paste ist es vorteilhaft, wenn die Klebefolie eine Klebefolie auf Silikonbasis ist, um ein leichtes und sicheres Ablösen des Klebebandes ohne Zerstörung der Leiterstruktur sicher zu stellen.

Bei einer bevorzugten Variante kann mit Vorteil vorgesehen sein, dass das Aufdrucken in Schritt b) mit Hilfe eines Siebdruckverfahrens erfolgt.

Weiters empfiehlt es sich, wenn die im Schritt e) aufgebrachte Isolierschicht im Bereich des zumindest einen Sensorchips eine Ausnehmung aufweist.

Die Erfindung samt weiteren Vorteilen ist im Folgenden an Hand einer beispielsweisen Ausführungsform näher erläutert, die in der Zeichnung veranschaulicht ist. In dieser zeigen
Fig. 1 in einem Schnitt ein in den ersten Schritten des Verfahrens hergestellten Aufbau, bestehend aus einer Klebefolie mit einer aufgedruckten Leiterstruktur aus einer leitfähigen Paste,
Fig. 2 den Aufbau der Fig. 1 nach Aufsetzen eines Sensorchips,
Fig. 3 den Aufbau nach Laminieren mit einem eine Leiterschicht aufweisenden Prepregs,
Fig. 4 die fertige Leiterplatte nach dem Abziehen der Klebefolie,
Fig. 5 in einem Schnitt die einzelnen Teile für eine Variante der Herstellung und
Fig. 6 eine schematische und teilweise Unteransicht auf die Leiterplatte nach Fig. 4.

Unter Bezugnahme auf die Figuren werden nun das Verfahren nach der Erfindung sowie eine erfindungsgemäße Leiterplatte erläutert. Dabei ist anzumerken, dass sich die im Folgenden verwendeten Begriffe "oben" und "unten" nur auf die Darstellungen in den Zeichnungen beziehen und zur Erleichterung der Beschreibung verwendet werden.

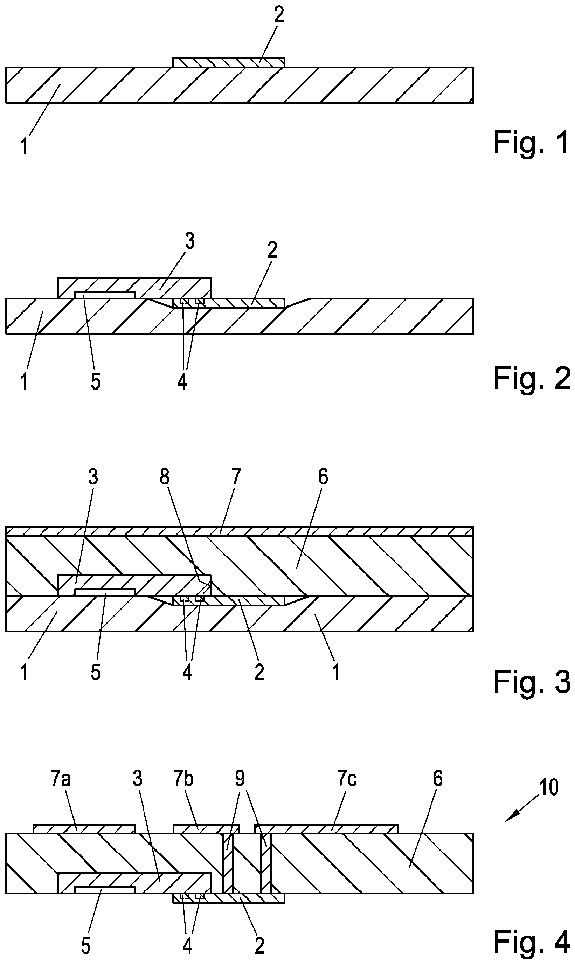

**Fig. 1** zeigt eine Klebefolie 1, welche Ausgangspunkt des erfindungsgemäßen Verfahrens ist. Diese Klebefolie 1 ist vorzugsweise eine Klebefolie mit einer Kleberschicht auf Silikonbasis, wobei die Gesamtdicke von Trägerfolie und Kleberschicht im Bereich von 50 und 300 µm liegen kann. Solche Klebefolien sind beispielsweise unter den Bezeichnungen Tacsil F20 der Firma Taconic im Handel erhältlich. Die einseitig klebende Klebefolie wird während des nachstehend beschriebenen Verfahrens auf einer glatten Oberfläche abgestützt, z.B. auf einem Vakuumtisch.

Auf eine Oberfläche dieser Klebefolie 1, in der Zeichnung die obere, wird nun, bevorzugt mittels eines Druckverfahrens, wie beispielsweise Siebdruck, Flexodruck, Offsetdruck, Tintenstrahldruck, eine Leiterstruktur 2 aus einer leitfähigen Paste aufgebracht. Die leitfähige Paste ist bevorzugt ein Epoxidharzkleber, wobei die Kombination "Epoxidharzkleber - Klebefolie auf Silikonbasis" besonders vorteilhaft ist, da sie ein späteres verlässliches und nicht zerstörendes Ablösen der Klebefolie begünstigt. Eine solche leitfähige Paste für das Aufbringen durch Siebdruck ist beispielsweise unter der Bezeichnung Epo-tek® H20E der Firma Epoxy Technology im Handel erhältlich, wobei sie durch Beigabe beispielsweise von Silber ihre Leitfähigkeit erhält, die im Bereich von über 2500 Ω⁻¹·m⁻¹ liegt. Die Schichtstärke der Leiterstruktur 2 kann bevorzugt im Bereich von 5 und 30 µm liegen.

In einem nächsten Schritt, siehe **Fig. 2****,** wird ein Sensorchip 3, dessen elektrische Anschlüsse 4 und dessen Sensorfläche 5 auf derselben Fläche des Chips liegen, auf die Leiterstruktur 2 aus leitfähiger Paste gesetzt. Dabei erfolgt das Aufsetzen registriert, d.h. die Anschlüsse 4 des Sensorchips 3 sind mit den entsprechenden Kontaktstellen der Leiterstruktur 2 ausgerichtet. Bei diesem Aufsetzen dringen die Anschlüsse 4 in die noch weiche Leiterstruktur 2 ein, sodass eine elektrische Verbindung geschaffen wird. Die leitfähige Paste der Leiterstruktur 2 wird nun ausgehärtet, beispielsweise durch thermisches oder UV-Härten.

Ein weiterer Schritt sieht nun vor, dass der Aufbau nach Fig. 2 in eine Isolierschicht 6 mit einer darüber liegenden Leiterschicht 7 zusammengefasst wird, was in **Fig. 3** dargestellt ist. Im vorliegenden Fall wird ein sogenanntes Core hergestellt, bestehend aus handelsüblichen Prepregs, z.B. FR 4, als Isolierschicht 6, und einer einzigen Leiterschicht 7, wobei die Isolierschicht 6 im Bereich des Sensorchips 3 zweckmäßigerweise eine Ausnehmung 8 aufweist, welche den Chip 3 aufnimmt. Der so erhaltene Aufbau wird einem üblichen Laminierprozess unterworfen, der auch zum Aushärten der Isolierschicht 6 führt.

Man erkennt aus Fig. 2 und 3, dass die Folie 1 im Bereich der Leiterstruktur 2 elastisch deformiert bzw. weggebogen wird, wobei allerdings anzumerken ist, dass dies in der Zeichnung übertrieben gezeigt ist, da die Zeichnung zur besseren Sichtbarmachung der einzelnen Teile nicht maßstäblich erstellt ist. Tatsächlich ist die Leiterstruktur 2 im Vergleich zur Folie sehr dünn, nämlich beispielsweise 10µm gegenüber beispielsweise 200µm.

Im Folgenden kann nun die Leiterschicht 7 in herkömmlicher Weise strukturiert werden, um einzelne Leiterzüge 7a, 7b, 7c zu erhalten. Weiters werden Durchkontaktierung (Vias) 9 zwischen oberen Leiterzügen und der Leiterstruktur 2 geschaffen. Dies erfolgt in bekannter Weise dadurch, dass zunächst Bohrungen durch den Aufbau hergestellt werden und diese sodann mit einem leitfähigen Material gefüllt oder ausgekleidet werden. Beispielsweise kann dies durch Abscheiden von Kupfer oder durch Auffüllen der Bohrungen mit einer leitfähigen Paste erfolgen. Es kann nun die Folie 1 abgezogen werden, wodurch auch die Sensorfläche freigelegt wird. Als Ergebnis liegt die in **Fig. 4** gezeigte Leiterplatte 10 vor.

Es sollte klar sein, dass die Darstellungen der Figuren 1 bis 4 im Allgemeinen nur einen Ausschnitt aus einer größeren Leiterplattenstruktur zeigen, und in der Praxis auf einer Leiterplatte mehrere Sensoren und andere Bauelemente an unterschiedlichen Stellen eingebettet bzw. vorgesehen und mit Leiterstrukturen verbunden sein können. Auch können auf eine Leiterplatte 10 nach Fig. 4 noch weitere Isolierschichten und leitende Schichten aufgebracht werden. Beispielsweise kann auf die Leiterstruktur 7a, 7b, 7c eine Isolierschicht und auf diese eine Leiterschicht folgen, wobei ebenso zwischen sämtlichen leitenden Schichten angeordnet sein können. Bei der Erfindung dient die leitfähige Paste einerseits zum Kontaktieren und andererseits zum (vorübergehenden) Fixieren des Sensorchips 3 auf der Folie 1, die sich, wie bereits erwähnt, nicht dauerhaft mit der Paste der Leiterstruktur 2 verbindet. Bei der Wahl der Materialien von leitfähiger Paste und der Folie 2 ist demnach die Forderung zu berücksichtigen, dass die Folie 2 ohne Zerstörung der Leiterstruktur 2 ablösbar sein muss.

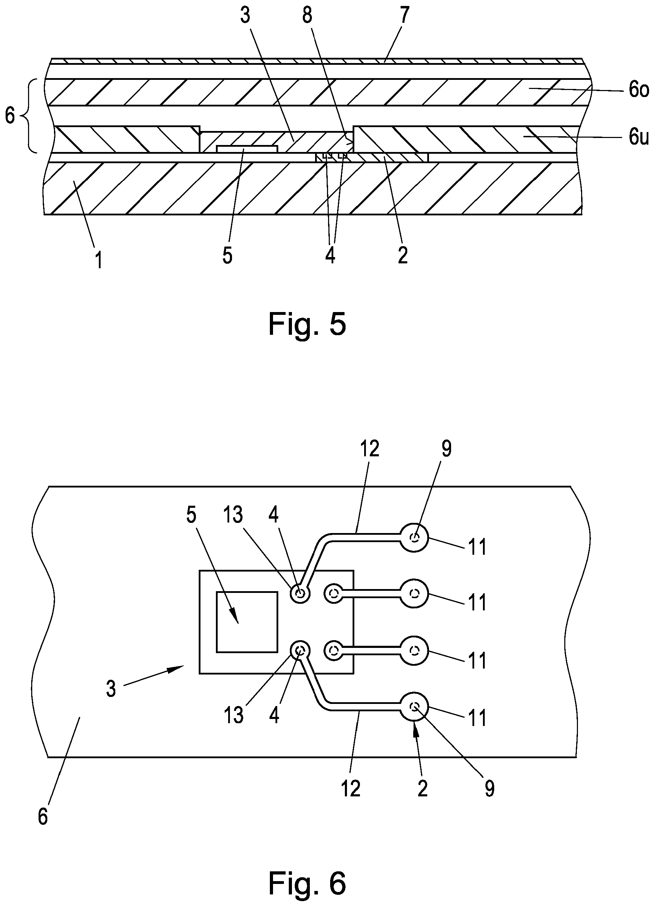

Was die Ausnehmung 8 für die Aufnahme des Sensorchips 3 betrifft, so sei noch auf **Fig. 5** verwiesen, welche eine Möglichkeit zeigt, wie der Chip 3 in die Isolierschicht 6 eingebettet werden kann. In dieser Figur sind die bereits aus den vorgehenden Figuren bekannten, für das Verfahren verwendeten Einzelteile gezeigt, wobei jedoch die Isolierschicht 6 aus zwei Einzellagen 6o und 6u besteht, von welchen die untere Einzelschicht 6u die den Sensorchip 3 aufnehmende Ausnehmung 8 besitzt. Die in Fig. 5 gezeigten Teile führen nach dem Laminieren zu einer Leiterplatte wie in Fig. 5 gezeigt. Es sei angemerkt, dass der weiter oben als "Core" bezeichnete Aufbau, dort bestehend aus einer Isolierschicht und einer Leiterschicht, auch auf andere Weise und in anderer Form hergestellt werden kann, ohne dabei von der Erfindung abzuweichen. So können die Prepregs 6o, 6u ihrerseits aus mehreren Prepregs bestehen, es können aber auch sogenannte "Bonding Sheets" unsymmetrische Prepregs, flüssige Harzmischungen oder andere Verfahren zur Herstellung des Cores verwendet werden.

Da der Sensorchip, wie bereits oben angemerkt, im Allgemeinen sehr dünn ist, wird man in vielen Fällen auch von der Ausbildung einer Ausnehmung 8 in der Isolierschicht 6 Abstand nehmen können. So kann im Fall einer Aufbringung der Isolierschicht in flüssiger Form sowie bei Materialien ohne Glasfaserverstärkung auf die Ausnehmung auch verzichtet werden.

Fig. 6 zeigt eine mögliche, in diesem Beispiel verwendete Leiterstruktur 2 in einer Unteransicht der Fig. 4. Man erkennt den rechteckigen Sensorchip 3 mit der Sensorfläche 5, die hier annähernd quadratisch ist, an der "Unterseite" des Chip, und vier elektrische Anschlüsse 4, die elektrisch mit der Leiterstruktur 2 aus einer leitfähigem Paste in Verbindung stehen und die strichliert gezeichnet sind. Diese Leiterstruktur weist den vier Anschlüssen entsprechend vier Anschlussaugen 11 auf, zu welchen die Vias 9 führen (siehe Fig. 4). Die Anschlussaugen 11 sind über Leiterzüge 12 mit Anschlussflächen 13 für die Chipanschlüsse 4 verbunden.

### Liste der Bezugszeichen

1 Klebefolie
2 Leiterstruktur
3 Sensorchip
4 Anschlüsse
5 Sensorfläche
6 Isolierschicht
7 Leiterschicht
8 Ausnehmung
9 Durchkontaktierungen
10 Leiterplatte
11 Anschlussaugen
12 Leiterzüge
13 Anschlussflächen

## Patentansprüche

1. Verfahren zum Herstellen einer Leiterplatte (10) mit zumindest einem eingebetteten Sensorchip (3), bei welchem zumindest eine Sensorfläche (5) und Anschlüsse (4) auf einer Fläche des Sensorchips (3) angeordnet sind,
**gekennzeichnet durch die folgenden Schritte in nachstehender Reihenfolge:**
a) Bereitstellen einer Klebefolie (1),
b) Aufdrucken einer Leiterstruktur (2) aus einer leitfähigen Paste auf eine Oberfläche der Klebefolie (1),
c) registriertes Aufsetzen des zumindest einen Sensorchips (3) mit der die zumindest eine Sensorfläche (5) und die Anschlüsse (4) aufweisenden Fläche auf die Leiterstruktur (2) aus einer leitfähigen Paste,
d) Aushärten der leitfähigen Paste,
e) Aufbringen einer Isolierschicht (6) mit einer darüber liegenden Leiterschicht (7) auf die den Sensorchip (3) aufweisende Oberfläche des in den vorgehenden Schritten geschaffenen Aufbaus, wobei die Isolierschicht (6) ein Prepreg ist,
f) Laminieren des in den vorgehenden Schritten geschaffenen Aufbaus,
g) Strukturieren der Leiterschicht (7) und Bilden von Durchkontaktierungen (9) von der Leiterschicht zu Leiterbahnen (7b, 7c) der Leiterstruktur auf der Oberfläche der Klebefolie (1) und
h) Entfernen der Klebefolie (1), wodurch die zumindest eine Sensorfläche (5) freigelegt wird.

2. Verfahren nach Anspruch 1, **dadurch gekennzeichnet, dass** die leitfähige Paste ein Epoxidharzkleber ist.

3. Verfahren nach Anspruch 1 oder 2, **dadurch gekennzeichnet, dass** in Schritt e) das Aushärten durch Anwendung von UV-Licht und/oder Wärme erfolgt.

4. Verfahren nach einem der Ansprüche 1 bis 3, **dadurch gekennzeichnet, dass** die Leiterschicht (7) eine Kupferschicht ist.

5. Verfahren nach einem der Ansprüche 1 bis 4, **dadurch gekennzeichnet, dass** die Klebefolie (1) eine Klebefolie auf Silikonbasis ist.

6. Verfahren nach einem der Ansprüche 1 bis 4, **dadurch gekennzeichnet, dass** das Aufdrucken in Schritt b) mit Hilfe eines Siebdruckverfahrens erfolgt.

7. Verfahren nach einem der Ansprüche 1 bis 5, **dadurch gekennzeichnet, dass** die im Schritt e) aufgebrachte Isolierschicht (6) im Bereich des zumindest einen Sensorchips (3) eine Ausnehmung (8) aufweist.

8. Leiterplatte (10), bestehend aus zumindest einer Isolierschicht (6, 6o, 6u) und zumindest einer strukturierten Leiterschicht (7a, 7b, 7c) mit zumindest einem eingebetteten Sensorchip (3), bei welchem zumindest eine Sensorfläche (5) und Anschlüsse (4) auf einer Fläche des Sensorchips (3) angeordnet sind, die abgewandt von der strukturierten Leiterschicht (7a, 7b, 7c) liegen, sowie die Anschlüsse (4) des Sensorchips (3) mit einer Leiterstruktur (2) verbunden sind und Durchkontaktierungen (9) von dieser Leiterstruktur (2) zu Leiterbahnen (7b, 7c) der strukturierten Leiterschicht verlaufen,
**wobei**
die Anschlüsse (4) des Sensorchips (3) mit einer aus einer leitfähigen Paste bestehenden Leiterstruktur (2) verbunden sind,
wobei der zumindest eine Sensorchip (3) in der zumindest einen Isolierschicht (6, 6o, 6u) eingebettet ist, und
die zumindest eine Isolierschicht (6, 6u), in die der Sensorchip (3) eingebettet ist, ein Prepreg ist,
wobei die Fläche des Sensorchips (3), an welcher die zumindest eine Sensorfläche (5) und die Anschlüsse (4) angeordnet sind, im Wesentlichen koplanar an einer Fläche der Leiterplatte (10) liegt, und wobei
die zumindest eine Sensorfläche (5) des Sensorchips (3) freigelegt ist.

9. Leiterplatte (10) nach Anspruch 8, **dadurch gekennzeichnet, dass** die Fläche des Sensorchips (3), an welcher die zumindest eine Sensorfläche (5) und die Anschlüsse (4) angeordnet sind, im Wesentlichen koplanar mit einer Oberfläche der zumindest einen Isolierschicht (6, 6u) liegt.

10. Leiterplatte (10) nach Anspruch 8 oder 9, **dadurch gekennzeichnet, dass** die Leiterstruktur (2) sowohl an der Fläche des Sensorchips (3), an welcher die zumindest eine Sensorfläche (5) und die Anschlüsse (4) angeordnet sind, als auch an der zu dieser Fläche des Sensorchips (3) im Wesentlichen koplanaren Oberfläche der Isolierschicht (6, 6u) anliegt, wobei die Anschlüsse (4) des Sensorchips (3) in die Leiterstruktur (2) eindringen und mit dieser (2) elektrisch verbunden sind.

11. Leiterplatte (10) nach einem der Ansprüche 8 bis 10, **dadurch gekennzeichnet, dass** eine Schichtstärke der Leiterstruktur (2) in einem Bereich zwischen 5 µm und 30 µm liegt.

## Claims

1. Method of manufacturing a printed circuit board (10) having at least one embedded sensor chip (3), in which at least one sensor surface (5) and terminals (4) are arranged on a surface of the sensor chip (3),
**characterized by** the following steps in the following order:
(a) providing an adhesive sheet (1),
b) imprinting a conductive structure (2) of a conductive paste on a surface of the adhesive sheet (1),
c) registered placing of the at least one sensor chip (3) with the surface having the at least one sensor surface (5) and the terminals (4) on the conductive structure (2) of a conductive paste,
d) curing the conductive paste,
e) applying an insulating layer (6) with an overlying conductive layer (7) to the surface comprising the sensor chip (3) of the structure created in the preceding steps, wherein the insulating layer (6) is a prepreg,
f) laminating the structure created in the preceding steps,
g) patterning the conductor layer (7) and forming vias (9) from the conductor layer to conductor tracks (7b, 7c) of the conductor pattern on the surface of the adhesive film (1), and
h) removing the adhesive film (1), thereby exposing the at least one sensor surface (5).

2. Method according to claim 1, **characterized in that** the conductive paste is an epoxy resin adhesive.

3. Method according to claim 1 or 2, **characterized in that** in step e) the curing is carried out by applying UV light and/or heat.

4. Method according to any one of claims 1 to 3, **characterized in that** the conductor layer (7) is a copper layer.

5. Method according to any one of claims 1 to 4, **characterized in that** the adhesive film (1) is a silicone-based adhesive film.

6. Method according to any one of claims 1 to 4, **characterized in that** the imprinting in step b) is carried out by means of a screen printing process.

7. Method according to one of claims 1 to 5, **characterized in that** the insulating layer (6) applied in step e) has a recess (8) in the region of the at least one sensor chip (3).

8. Printed circuit board (10), comprising at least one insulating layer (6, 6o, 6u) and at least one structured conductor layer (7a, 7b, 7c) with at least one embedded sensor chip (3), in which at least one sensor surface (5) and connections (4) are arranged on a surface of the sensor chip (3) facing away from the structured conductor layer (7a, 7b, 7c), and the terminals (4) of the sensor chip (3) are connected to a conductor structure (2) and through-platings (9) run from this conductor structure (2) to conductor tracks (7b, 7c) of the structured conductor layer,
wherein
the terminals (4) of the sensor chip (3) are connected to a conductor structure (2) consisting of a conductive paste,
wherein the at least one sensor chip (3) being embedded in the at least one insulating layer (6, 6o, 6u), and
wherein the at least one insulating layer (6, 6u) in which the sensor chip (3) is embedded is a prepreg, wherein the surface of the sensor chip (3) on which the at least one sensor surface (5) and the terminals (4) are arranged is substantially coplanar with a surface of the printed circuit board (10), and wherein
the at least one sensor surface (5) of the sensor chip (3) is exposed.

9. Printed circuit board (10) according to claim 8, **characterized in that** the surface of the sensor chip (3) on which the at least one sensor surface (5) and the terminals (4) are arranged lies substantially coplanar with a surface of the at least one insulating layer (6, 6u).

10. Printed circuit board (10) according to claim 8 or 9, **characterized in that** the conductor structure (2) bears both against the surface of the sensor chip (3), on which surface of the sensor chip (3) the at least one sensor surface (5) and the terminals (4) are arranged, and against the surface of the insulating layer (6, 6u), which surface of the insulating layer (6, 6u) is essentially coplanar with the aforesaid surface of the sensor chip (3), wherein the terminals (4) of the sensor chip (3) penetrating into the conductor structure (2) and being electrically connected to the latter (2).

11. Printed circuit board (10) according to any one of claims 8 to 10, **characterized in that** a layer thickness of the conductor structure (2) is in a range between 5 µm and 30 µm.

## Revendications

1. Procédé de fabrication d'une carte de circuit imprimé (10) comportant au moins une puce de capteur (3) intégrée, dans lequel au moins une surface de capteur (5) et des bornes (4) sont disposées sur une surface de la puce de capteur (3),
**caractérisé par** les étapes suivantes dans l'ordre suivant :
a) en fournissant une feuille adhésive (1),
b) l'impression d'une structure conductrice (2) d'une pâte conductrice sur une surface de la feuille adhésive (1),
c) l'enregistrement d'au moins une puce de capteur (3) avec la surface ayant au moins une surface de capteur (5) et les bornes (4) sur la structure conductrice (2) d'une pâte conductrice,
d) le durcissement de la pâte conductrice,
e) application d'une couche isolante (6) avec une couche conductrice (7) superposée sur la surface comprenant la puce de capteur (3) de la structure créée dans les étapes précédentes, dans laquelle la couche isolante (6) est un préimprégné,
f) le laminage de la structure créée dans les étapes précédentes,
g) la structuration de la couche conductrice (7) et la formation de traversées (9) de la couche conductrice aux pistes conductrices (7b, 7c) du motif conducteur sur la surface du film adhésif (1), et
h) enlever le film adhésif (1), exposant ainsi la ou les surfaces des capteurs (5).

2. Procédé selon la revendication 1, **caractérisée en ce que** la pâte conductrice est un adhésif à base de résine époxy.

3. Procédé selon la revendication 1 ou 2, **caractérisée en ce que** dans l'étape e), le durcissement est effectué par application de lumière UV et/ou de chaleur.

4. Procédé selon l'une quelconque des revendications 1 à 3, **caractérisé en ce que** la couche conductrice (7) est une couche de cuivre.

5. Procédé selon l'une quelconque des revendications 1 à 4, **caractérisée en ce que** le film adhésif (1) est un film adhésif à base de silicone.

6. Procédé selon l'une quelconque des revendications 1 à 4, **caractérisée en ce que** l'impression à l'étape b) est effectuée au moyen d'un procédé de sérigraphie.

7. Procédé selon l'une quelconque des revendications 1 à 5, **caractérisé en ce que** la couche isolante (6) appliquée à l'étape e) présente un évidement (8) dans la zone de l'au moins une puce de capteur (3).

8. Carte de circuit imprimé (10), comprenant au moins une couche isolante (6, 6o, 6u) et au moins une couche conductrice structurée (7a, 7b, 7c) avec au moins une puce de capteur (3) intégrée, dans laquelle au moins une surface de capteur (5) et des connexions (4) sont disposées sur une surface de la puce de capteur (3) qui sont éloignés de la couche conductrice structurée (7a, 7b, 7c), et les bornes (4) de la puce de capteur (3) sont reliées à une structure conductrice (2) et des plaques traversantes (9) s'étendent de cette structure conductrice (2) aux pistes conductrices (7b, 7c) de la couche conductrice structurée,
dans lequel
les bornes (4) de la puce de capteur (3) sont reliées à une structure conductrice (2) constituée d'une pâte conductrice,
dans lequel l'au moins une puce de capteur (3) est incorporée dans l'au moins une couche isolante (6, 6o, 6u), et
dans lequel l'au moins une couche isolante (6, 6u) dans laquelle la puce de capteur (3) est encastrée est un préimprégné,
dans lequel la surface de la puce de capteur (3) sur laquelle l'au moins une surface de capteur (5) et les bornes (4) sont disposées est sensiblement coplanaire avec une surface de la carte de circuit imprimé (10), et dans lequel
l'au moins une surface de capteur (5) de la puce de capteur (3) est exposée.

9. Carte de circuit imprimé (10) selon la revendication 8, **caractérisée en ce que** la surface de la puce de capteur (3) sur laquelle l'au moins une surface de capteur (5) et les bornes (4) sont disposées est sensiblement coplanaire avec une surface de l'au moins une couche isolante (6, 6u).

10. Carte de circuit imprimé (10) selon la revendication 8 ou 9, **caractérisée en ce que** la structure conductrice (2) porte à la fois contre la surface de la puce de capteur (3), surface de la puce de capteur (3) sur laquelle sont disposées l'au moins une surface de capteur (5) et les bornes (4), et contre la surface de la couche isolante (6, 6u), laquelle surface de la couche isolante (6, 6u) est essentiellement coplanaire avec la surface susmentionnée de la puce de capteur (3), les bornes (4) de la puce de capteur (3) pénétrant dans la structure conductrice (2) et étant connectées électriquement à cette dernière (2).

11. Carte de circuit imprimé (10) selon l'une quelconque des revendications 8 à 10, **caractérisée en ce qu'**une épaisseur de couche de la structure conductrice (2) se situe dans une plage comprise entre 5 µm et 30 µm.
